# EUROPÄISCHE PATENTANMELDUNG

(11) **EP 4 324 680 A1**
(43) Veröffentlichungstag der Anmeldung: **21.02.2024**
(21) Anmeldenummer: 23186785.4
(22) Anmeldetag: 20.07.2023
(51) Int. Cl.: B60L 1/02, B60L 53/302, H01R 13/533

(54) **KONTAKTIERUNGSPINTRÄGER FÜR EIN KONTAKTIERUNGSELEMENT, KONTAKTIERUNGSELEMENT FÜR EINE STECKVERBINDUNGSEINRICHTUNG SOWIE STECKVERBINDUNGSEINRICHTUNG**

(30) Priorität: 19.08.2022 DE 102022120988
(71) Anmelder: Lisa Dräxlmaier GmbH, 84137 Vilsbiburg (DE)
(72) Erfinder: Schmittat, Lutz, 84137 Vilsbiburg (DE); Heckelsmüller, Stephan, 85386 Eching (DE)

(57) **Zusammenfassung**

Die Erfindung betrifft einen Kontaktierungspinträger (1) für ein Kontaktierungselement (2), der einen Kühlkörper (6) aufweist, welcher eine mit einem elektrisch nichtleitenden Kühlmittel durchströmbare Kühlmittelkammer (7) begrenzt, aus einem elektrisch leitfähigen Material ausgebildet ist, sowie einen Kühlmittelkammeranteil (16) und einen Kühlmittelkammerdeckel (17) aufweist, die miteinander verbunden sind. Eine Einströmöffnung (18) und eine Ausströmöffnung (19) durchdringen einen Kühlmittelkammerdeckel (17), münden in die Kühlmittelkammer (7) und sind dazu eingerichtet, außenseitig des Kühlkörpers (6) mit einem Zulaufkanal bzw. einem Rücklaufkanal eines Kühlmittelkreislaufs fluidisch verbunden zu werden. Die Erfindung betrifft zudem ein Kontaktierungselement (2), das den Kontaktierungspinträger (1) aufweist, an dessen Kühlkörper (6) ein Kontaktierungspin (4) angeordnet und elektrisch mit dem Kühlkörper (6) kontaktiert ist. Weiter betrifft die Erfindung eine Steckverbindungseinrichtung (3) mittels derer eine elektrisch leitfähige Steckverbindung (3) herstellbar ist.

## Beschreibung

### Technisches Gebiet

Die vorliegende Erfindung betrifft einen Kontaktierungspinträger für ein Kontaktierungselement einer zum Herstellen einer elektrisch leitfähigen Steckverbindung ausgebildeten Steckverbindungseinrichtung. Eine solche Steckverbindungseinrichtung findet sich insbesondere bei Kraftfahrzeugen, die eine als elektrische Sekundärbatterie ausgebildete Traktionsbatterie aufweisen, die dazu eingerichtet ist, einer elektrischen Antriebseinheit des Kraftfahrzeugs elektrische Traktionsenergie bereitzustellen. Bei dem Kraftfahrzeug handelt es sich also zum Beispiel um ein reinelektrisch antreibbares Kraftfahrzeug oder um ein Hybrid-Kraftfahrzeug. Ferner betrifft die Erfindung ein Kontaktierungselement für die Steckverbindungseinrichtung, wobei das Kontaktierungselement den Kontaktierungspinträger aufweist. Zudem betrifft die Erfindung eine Steckverbindungseinrichtung, die insbesondere kraftfahrzeugseitig angeordnet ist und zum Bilden/Schließen eines Lade- und/oder Entladestromkreises (um die Batterie zu laden bzw. zu entladen) mit einer Gegensteckverbindungseinrichtung einer Energiequelle, zum Beispiel einem infrastrukturellen Stromnetz, mechanisch und elektrisch korrespondiert.

### Stand der Technik

Heutzutage besteht der Bedarf, eine Traktionsbatterie eines ganz oder teilweise elektrisch antreibbaren Kraftfahrzeug besonders effizient und insbesondere schnell elektrisch zu laden. Durch die dabei entstehenden hohen Ladeleistungen erwärmen sich stromführenden Elemente, wie Kabel, Kontaktierungselemente (Pins) etc., wobei mit steigender Temperatur ein ohmscher Widerstand des entsprechenden stromführenden Elements steigt, was wiederum einem gewünscht hohen Maß an elektrischer Ladeleistung entgegensteht. Insbesondere aufgrund von Packaging-Vorgaben bei der Entwicklung von Kraftfahrzeugen ist ein effizientes Kühlen der stromführenden Elemente nur unter Einsatz von besonders hohem Aufwand möglich. Zudem wird die Wärmeabfuhr aufgrund einer zumeist beengten Bauraumsituation zusätzlich erschwert.

### Beschreibung der Erfindung

Aufgabe der Erfindung ist es, eine besonders hohe Ladeleistung beim Laden einer Batterie, insbesondere einer Traktionsbatterie eines Kraftfahrzeugs, zu ermöglichen.

Diese Aufgabe wird durch die Gegenstände der unabhängigen Patentansprüche gelöst. Weitere mögliche Ausgestaltungen der Erfindung sind in den Unteransprüchen, der Beschreibung und den Figuren offenbart. Merkmale, Vorteile und mögliche Ausgestaltungen, die im Rahmen der Beschreibung für einen der Gegenstände der unabhängigen Ansprüche dargelegt sind, sind zumindest analog als Merkmale, Vorteile und mögliche Ausgestaltungen des jeweiligen Gegenstands der anderen unabhängigen Ansprüche sowie jeder möglichen Kombination der Gegenstände der unabhängigen Ansprüche, gegebenenfalls in Verbindung mit einem oder mehr der Unteransprüche, anzusehen.

Gemäß der Erfindung wird ein Kontaktierungspinträger für ein Kontaktierungselement vorgeschlagen, wobei das Kontaktierungselement für eine Steckverbindungseinrichtung vorgesehen ist. Zudem schlägt die Erfindung das Kontaktierungselement vor, das den Kontaktierungspinträger und einen Kontaktierungspin aufweist, der an einem Kühlkörper des Kontaktierungspinträgers angeordnet und mit diesem elektrisch kontaktiert ist. Darüber hinaus wird eine Steckverbindungseinrichtung für ein Kraftfahrzeug vorgeschlagen, mittels derer eine elektrisch leitfähige Steckverbindung zwischen einer elektrischen Energiequelle (etwa einer Ladeinfrastruktur) und einer elektrischen Batterie (etwa einer Traktionsbatterie eines Kraftfahrzeugs) herstellbar ist, indem die Steckverbindungseinrichtung und eine korrespondierende Gegensteckverbindungseinrichtung elektrisch miteinander gekoppelt werden. Auf diese Weise wird zwischen der Batterie und der Energiequelle eine elektrisch leitfähige Steckverbindung ausgebildet.

Der Kontaktierungspinträger weist den Kühlkörper auf, der eine mit einem elektrisch isolierenden bzw. elektrisch nichtleitenden Kühlmittel durchströmbare Kühlmittelkammer begrenzt und aus einem elektrisch leitfähigen Material ausgebildet ist. Der Kühlkörper ist insbesondere aus einem metallischen Material, etwa einem Metall, einer Metalllegierung etc. ausgebildet. Beispielsweise kommt hierzu Kupfer in Frage. Der Kühlkörper weist einen Kühlmittelkammeranteil und einen Kühlmittelkammerdeckel auf. Der Kühlmittelkammerdeckel und der Kühlmittelkammeranteil können aus gleichem Material oder aus unterschiedlichen Materialien ausgebildet sein, sind aber jedenfalls beide elektrisch leitfähig und elektrisch miteinander kontaktiert. Der Kühlmittelkammeranteil und der Kühlmittelkammerdeckel bilden miteinander den Kühlkörper zumindest teilweise und umschließen die Kühlmittelkammer (abgesehen von einer Einströmöffnung und einer Ausströmöffnung, die weiter unten noch genauer beschrieben werden). Der Kühlkörper, der die Kühlmittelkammer (abgesehen von der Einströmöffnung und der Ausströmöffnung) vollständig umschließt kann als ein monolithisches Teil ausgeführt sein. Dies wird beispielsweise dadurch erreicht, wenn der Kühlkörper generativ/additiv hergestellt ist. Mit anderen Worten: Der Kühlmittelkammerdeckel und der Kühlmittelkammeranteil können in einem gemeinsamen generativen/additiven Herstellungsprozess hergestellt werden, wobei dadurch der Kühlkörper gebildet wird. Dabei können die Ein- und die Ausströmöffnung im selben Herstellungsprozess mitausgebildet werden oder nach dem Herstellungsprozess gebohrt/geschnitten werden. In diesem Fall ist der Kühlkörper besonders zuverlässig, da er - selbst ohne spezielle Dichtungsmaßnahmen - abseits der Öffnungen fluidisch dicht ist. Denn das Kühlmittel tritt nicht in unerwünschter Weise abseits der Öffnungen aus der Kühlmittelkammer aus und gelangt folglich nicht in die Umgebung des Kühlkörpers, sodass wirksam verhindert ist, dass das Kühlmittel außerhalb des Kühlkörpers Schaden verursacht.

Der Kontaktierungspinträger weist insbesondere eine Befestigungseinrichtung auf, die an dem Kühlkörper ausgebildet ist und dazu eingerichtet ist, einen Kontaktierungspin des Kontaktierungselements außenseitig am Kühlkörper kraft-, form- und/oder stoffschlüssig zu fixieren und dabei den Kontaktierungspin mit dem Kühlkörper elektrisch zu kontaktieren. Insoweit fungiert die Befestigungseinrichtung als mechanische Befestigungseinrichtung, mittels derer der Kontaktierungspin am Kühlkörper mechanisch positionsfest gehalten ist, und gleichzeitig als elektrische Kontaktierungseinrichtung, mittels derer der Kontaktierungspin und der Kühlkörper elektrisch miteinander kontaktiert sind. Dementsprechend ist der Kontaktierungspin aus einem elektrisch leitfähigen Material ausgebildet, bei dem es sich beispielsweise um das gleiche Material wie bei dem Kühlkörper handeln kann. Der Kontaktierungspin kann als ein Hohlpin ausgeführt sein, dessen Kontaktierungsabschnitt in Form eines geraden Kreisringzylinders ausgeführt ist. Ferner ist ein Vollpin denkbar, dessen Kontaktierungsabschnitt in Form eines geraden Kreiszylinders ausgeführt ist. Auch ein anderer Querschnitt des Kontaktierungsabschnitts ist denkbar, zum Beispiel ein elliptischer, ovaler, polygonaler Querschnitt. Für das Kontaktierungselement gilt also, dass der Kontaktierungspin mittels der Befestigungseinrichtung des Kontaktierungspinträgers am Kühlkörper des Kontaktierungspinträgers fixiert und mit diesem dadurch elektrisch kontaktiert sein kann.

Des Weiteren weist der Kontaktierungspinträger eine Einströmöffnung und eine davon separat ausgebildete Ausströmöffnung auf, wobei die Einströmöffnung den Kühlkörper, insbesondere dessen Kühlmittelkammerdeckel, durchdringt und in die Kühlmittelkammer mündet. Die Einströmöffnung ist dazu eingerichtet, außenseitig des Kühlkörpers mit einem Zulaufkanal eines Kühlmittelkreislaufs, der beispielsweise Teil der Steckverbindungseinrichtung sein kann, fluidisch verbunden zu werden. Die Ausströmöffnung durchdringt den Kühlkörper, insbesondere dessen Kühlmittelkammerdeckel, an anderer Stelle als die Einströmöffnung und mündet ebenfalls in die Kühlmittelkammer. Die Ausströmöffnung ist dazu eingerichtet, außenseitig des Kühlkörpers mit einem Rücklaufkanal des Kühlmittelkreislaufs fluidisch verbunden zu werden. Der Kühlmittelkreislauf der Steckverbindungseinrichtung weist ein Kühlmittelkanalwerk (zum Beispiel ein Rohr- und/oder Schlauchwerk) und ein fluidisch in das Kühlmittelkanalwerk integriertes Kühlmittelantriebselement (eine Kühlmittelpumpe, falls als Kühlmittel eine Kühlflüssigkeit eingesetzt wird, oder ein Kühlmittelgebläse, falls als Kühlmittel ein Kühlgas eingesetzt wird) auf.

Die Einströmöffnung und die Ausströmöffnung sind beispielsweise kreisrund ausgebildet und können gemeinsam mit dem Kühlkörper, insbesondere dessen Kühlmittelkammerdeckel, urgeformt sein. Die Öffnungen, das heißt die Einströmöffnung und die Ausströmöffnung, können zum Beispiel im Rahmen eines generativen und/oder additiven Herstellens des Kühlkörpers (oder eines Teils davon) oder im Rahmen eines Gießens eines Kühlrohkörpers (oder eines Teils davon) ausgebildet werden. Bei dem Kühlrohkörpers kann es sich um ein Zwischenprodukt handeln, das zum Herstellen des Kühlkörpers spanend und/oder spanlos nachbearbeitet werden kann. Die Öffnungen können alternativ in einem separaten Herstellungsprozessschritt (das heißt nach dem Urformen des Kühlkörpers bzw. Kühlrohkörpers) gebildet worden sein, etwa mittels Bohrens und/oder Honens und/oder Schneidens (insbesondere Laserschneidens) und/oder Fräsens etc. einer entsprechenden Wand des Kühlkörpers bzw. Kühlrohkörpers. Die Kühlmittelkammer ist nach außen hin - abgesehen von den beiden Öffnungen - fluidisch dicht, sodass abseits der Öffnungen ein Austreten des Kühlmittels aus der Kühlmittelkammer heraus in eine Umgebung des Kühlkörpers verhindert ist. Die Öffnungen können beide in dem Kühlmittelkammerdeckel ausgebildet sein. Alternativ kann vorgesehen sein, dass eine der Öffnungen, beispielsweise die Einströmöffnung, den Kühlmittelkammerdeckel durchdringt, wohingegen die entsprechend andere der Öffnungen, etwa die Ausströmöffnung, den Kühlmittelkammeranteil durchdringt. Auch eine Ausführung des Kühlkörpers, bei dem die beiden Öffnungen den Kühlmittelkammeranteil durchdringen, ist denkbar.

Der Kontaktierungspinträger ermöglicht es, einen Kontaktierungspin besonders wirksam und effizient aktiv zu kühlen. Denn im Betrieb des Kontaktierungspinträgers bzw. des Kontaktierungselements bzw. der Steckverbindungseinrichtung wird die Kühlmittelkammer mit dem Kühlmittel durchströmt bzw. durchspült, wodurch Wärme aus dem Kühlkörper in das die Kühlmittelkammer durchströmende Kühlmittel übergeht und mittels des Kühlmittels abtransportiert wird. Die Wärme, die mittels des Kühlmittels aus dem Kühlkörper abtransportiert wird, ist insbesondere die Wärme, die aufgrund eines den Kontaktierungspin durchfließenden elektrischen Stroms im Material des Kontaktierungspins erzeugt und - gegebenenfalls über die Befestigungseinrichtung - in das Material des Kontaktierungspinträgers und demnach in den Kühlkörper geleitet wird. Um den Wärmeübergang zwischen dem Kontaktierungspin und dem Kühlkörper sowie zwischen dem Kühlkörper und dem Kühlmittel zu begünstigen, ist vorgesehen, dass als das jeweilige elektrisch leitfähige Material des Kontaktierungspins und des Kühlkörpers ein solches gewählt wird, das einen besonders hohe Wärmeleitfähigkeit aufweist. Indem im Betrieb der Kontaktierungspin und der Kühlkörper aktiv mittels des Kühlmittels gekühlt werden, wird einem Erhöhen des ohmschen Widerstands aufgrund des fließenden Stroms wirksam entgegengewirkt, sodass im Vergleich mit ungekühlten oder passivgekühlten stromführenden Elementen besonders hohe Lade- und/oder Entladeleistungen darstellbar sind. Zusätzlich weist der Kontaktierungspinträger eine Doppelfunktionalität auf, da er im Betrieb - erstens - als Wärmesenke für den Kontaktierungspin fungiert und - zweitens - als stromführendes Element fungiert. So ist ein besonders effizientes Kühlen ermöglicht, da das stromführende Element selbst, also der Kontaktierungspinträger selbst, direkt mit dem Kühlmittel durchströmt wird. Ferner ist der Kontaktierungspinträger besonders bauraumeffizient und ausgebildet.

Um bei einem vorgegebenen Pitch-Maß (das ist ein gerader Abstand zwischen zwei direkt zueinander benachbarten Kontaktierungspins derselben Kontaktierungseinheit) eine besonders voluminöse und damit den Wärmeabtransport besonders effizient unterstützende Kühlmittelkammer zu erlangen, ist insbesondere vorgesehen, dass der Kühlkörper - und infolgedessen die Kühlmittelkammer - asymmetrisch ausgeführt ist. Dies führt zu einer exzentrischen Anordnung der Befestigungseinrichtung (sofern diese vorhanden ist) bzw. - bei dem Kontaktierungselement - des Kontaktierungspins in Bezug zu der Kühlmittelkammer. Durch diese exzentrische bzw. asymmetrische Anordnung kann das Pitch-Maß besonders klein vorgegeben werden, was wiederum eine besonders bauraumeffiziente Ausgestaltung des Kühlkörpers und infolgedessen des Kontaktierungselements ermöglicht.

Eine weitere mögliche Ausführungsform sieht vor, dass der Kühlmittelkammeranteil und der Kühlmittelkammerdeckel separat voneinander hergestellt und kraft-, form- und/oder stoffschlüssig miteinander verbunden sind. Anders ausgedrückt: der Kühlkörper weist den Kühlmittelkammeranteil und den Kühlmittelkammerdeckel auf, die zum Bilden des Kühlkörpers separat voneinander bereitgestellt wurden und dann zu dem Kühlkörper zusammengesetzt, beispielsweise gefügt sind. Bei dem Kühlkörper ist dann der Kühlmittelkammerdeckel kraft-, form- und/oder stoffschlüssig mit einer korrespondierenden Deckelöffnung des Kühlmittelkammeranteils verbunden, wodurch die Kühlmittelkammer (abgesehen von den Stellen der Einströmöffnung und der Ausströmöffnung) von dem Kühlmittelkammeranteil zusammen mit dem Kühlmittelkammerdeckel vollständig umschlossen ist. Zum Beispiel können der Kühlmittelkammerdeckel und der Kühlmittelkammeranteil reversibel zerstörungsfrei lösbar und dabei fluidisch dicht aneinander befestigt, insbesondere miteinander verschraubt sein. Eine solche zwei- oder mehrteilige Ausführung des Kühlkörpers ist insofern vorteilhaft, als der Kühlkörper zum Beispiel zu Reinigungs-, Reparatur- und/oder Wartungszwecken zerlegbar ist. Zwischen dem Kühlmittelkammeranteil und dem Kühlmittelkammerdeckel kann zur Sicherung der Dichtwirkung im an der Deckelöffnung ein Dichtmittel angeordnet sein, etwa eine torusförmige Ringdichtung, eine Ringscheibendichtung, eine zunächst pastöse und anschließend ausgehärtete Dichtmasse etc.

Ein besonders sicherer bzw. fester Sitz des Kühlkörperdeckels am Kühlmittelkammeranteil und gleichzeitig eine besonders zuverlässige elektrische Verbindung zwischen dem Kühlkörperdeckel und dem Kühlmittelkammeranteil wird erreicht, wenn zwischen dem Kühlkörperdeckel und dem Kühlmittelkammeranteil, eine Schweißverbindung ausgeführt ist, die zum Beispiel mittels Reib-, Ultraschall- und/oder Laserschweißens erzeugt ist. Ferner - sofern eine Oberflächenbeschaffenheit für das Erzeugen einer gleichmäßigen Kontaktkraft entlang den Flächen, über welche der Kühlkörperdeckel und der Kühlmittelkammeranteil aneinander anliegen - qualitativ ausreicht, können Kühlkörperdeckel und Kühlmittelkammeranteil miteinander verschraubt sein. Alternativ oder zusätzlich sind andersartige kraft-, form- und/oder stoffschlüssige und dabei jedenfalls elektrisch leitende Verbindungen zwischen Kühlmittelkammeranteil und Kühlmittelkammerdeckel denkbar. So kommt beispielsweise in Frage, einen elektrisch leitfähigen Klebstoff zwischen dem Kühlkörperdeckel und dem Kühlmittelkammeranteil zu applizieren, sodass die Verbindungsvorrichtung dann eine Klebeverbindung aufweist.

In einer weiteren möglichen Ausführungsform ist vorgesehen, dass der Kühlmittelkammerdeckel als ein Stromschienenkörper für das Kontaktierungselement ausgebildet ist. Das bedeutet, dass der Kühlmittelkammerdeckel einen Anschlussabschnitt aufweist, der stoffschlüssig mit einem Hauptkörperabschnitt des Kühlmittelkammerdeckels verbunden ist. Insbesondere sind der Hauptkörperabschnitt und der Anschlussabschnitt einstückig miteinander ausgebildet, zum Beispiel miteinander aus demselben Material urgeformt. Der Stromschienenkörper - das heißt der Kühlmittelkammerdeckel - ist dabei dazu eingerichtet, mit einem elektrischen Bordnetz des Kraftfahrzeugs elektrisch leitend verbunden zu werden. Für den Kontaktierungspinträger gilt also gemäß dieser Ausführungsform, dass der Kühlmittelkammeranteil, indem er an dem Kühlmittelkammerdeckel mechanisch befestigt bzw. gelagert ist, an dem Stromschienenkörper befestigt/gelagert ist. Indem der Stromschienenkörper bzw. Kühlmittelkammerdeckel zum einen als stromführendes Element und zum anderen als mechanisches Lager für den Kühlmittelkammeranteil fungiert, ist das Kontaktierungspinträger besonders bauteilarm und bauraumeffizient ausgebildet. Zudem ist eine besonders effiziente Wärmeabfuhr vom Stromschienenkörper möglich, da das in der Kühlmittelkammer strömende Kühlmittel den Stromschienenkörper direkt überstreicht. Dies führt zu einer besonders effizienten Kühlung des Kontaktierungspinträgers insgesamt. Des Weiteren ermöglichen die Form und Größe des Stromschienenkörpers, mittels dessen der Kontaktierungspinträger an das Bordnetz des Kraftfahrzeugs angeschlossen werden kann, dass das Kontaktierungselement oder die Steckverbindungseinrichtung unter Einsatz von besonders wenig Aufwand an länderspezifische Zulassungs- bzw. Homologationsvorgaben angepasst werden kann. Ein Umgestalten des Kühlmittelkammeranteils entfällt dabei in vorteilhafter Weise.

Gemäß einer weiteren möglichen Ausgestaltung ist in der Kühlmittelkammer ein Kühlmittelkanal ausgebildet, der sich einerseits fluidisch an die Einströmöffnung und andererseits fluidisch an die Ausströmöffnung anschließt. Dabei ist durch den Kühlmittelkanal ein Mäander in der Kühlmittelkammer gebildet. Es ist ferner denkbar, dass durch den in der Kühlmittelkammer verlaufenden Kühlmittelkanal zwei oder mehr Mäander gebildet sind. Hierzu weist der Kühlmittelkanal Kühlmittelkanalwände auf, die sind in der Kühlmittelkammer zwischen dem Kühlmittelkammeranteil und dem Kühlmittelkammerdeckel erstrecken, sodass der Kühlmittelkanal durch den Kühlmittelkammeranteil, den Kühlmittelkammerdeckel und die Kühlmittelkanalwände begrenzt wird. Die Kühlmittelkanalwände können separat von dem Kühlmittelkammerdeckel und dem Kühlmittelkammeranteil als ein Einsatz für die Kühlmittelkammer hergestellt sein, wobei der Einsatz zwischen den Kühlmittelkammerdeckel und den Kühlmittelkammeranteil eingespannt und dadurch positionell fixiert ist. Alternativ oder zusätzlich können zwischen dem Einsatz und dem Kühlmittelkammerdeckel und/oder dem Kühlmittelkammeranteil eine Klebeverbindung ausgebildet sein, die als Dichtungselement fungiert. Die Kühlmittelkanalwände können weiter einstückig mit dem Kühlmittelkammeranteil oder einstückig mit dem Kühlmittelkammerdeckel ausgebildet sein. Zudem ist es denkbar, dass einige der Kühlmittelkanalwände einstückig mit dem Kühlmittelkammeranteil ausgebildet sind, wobei andere der Kühlmittelkanalwände desselben Kühlmittelkanals einstückig mit dem Kühlmittelkammerdeckel ausgebildet sind. Durch die Mäander des Kühlmittelkanals strömt/streicht das Kühlmittel im Betrieb besonders großflächig am Kühlmittelkammeranteil bzw. am Kühlmittelkammerdeckel entlang, sodass besonders viel Wärme aufgenommen wird und sowohl Kühlmittelkammerdeckel als auch Kühlmittelkammeranteil besonders effizient gekühlt werden.

In einer weiteren möglichen Ausgestaltung ist vorgesehen, dass der Kontaktierungspinträger mittels eines spanlosen Fertigungsverfahrens und/oder mittels eines spanenden Fertigungsverfahrens hergestellt ist. Mit anderen Worten kann der Kühlmittelkammeranteil mittels eines spanlosen Fertigungsverfahrens und/oder mittels eines spanenden Fertigungsverfahrens hergestellt sein. Alternativ oder zusätzlich kann der Kühlmittelkammerdeckel mittels eines spanlosen Fertigungsverfahrens und/oder mittels eines spanenden Fertigungsverfahrens hergestellt sein. Insbesondere ist der Kühlmittelkammeranteil mittels Kaltfließpressens hergestellt. Ferner ist ein additives bzw. generatives Fertigungsverfahren sowohl für den Kühlmittelkammeranteil und/oder den Kühlmittelkammerdeckel denkbar, zum Beispiel ein 3D-Drucken, ein pulverbettbasiertes (Laser-)Schmelzen etc. Ferner kommt ein Drehen, ein Fräsen etc. in Frage, insbesondere zum Nachbearbeiten eines Kühlmittelkammerrohanteils des Kühlrohkörpers, nachdem der Kühlmittelkammerrohanteil spanlos hergestellt wurde. Hierdurch kann der Kontaktierungspinträger, insbesondere dessen Kühlkörper, besonders einfach und effizient hergestellt werden. Darüber hinaus kann eine Oberflächenbearbeitung bzw. -veredelung erfolgen, beispielsweise kann der Kühlkörper außenseitig und/oder innenseitig mit einer Korrosionsschutzbeschichtung beschichtet sein. Ferner ist es denkbar, dass die Kühlmittelkammer mit einer innenseitigen strömungsbeeinflussenden Oberflächenstruktur ausgebildet ist, zum Beispiel mit Strömungsrippen oder sonstigen Strömungslenkelementen. So wird dem Gedanken an einen effizienten kühlmittelbasierten Wärmeabtransport in besonderem Maße Rechnung getragen.

In weiterer möglicher Ausführungsform weist der Kontaktierungspinträger für eine der Öffnungen ein Kanalkopplungselement auf. Insbesondere weist der Kontaktierungspinträger ein für die Einströmöffnung vorgesehenes, erstes Kanalkopplungselement und ein für die Ausströmöffnung vorgesehenes, zweites Kanalkopplungselement auf. Ein jeweiliges erstes Ende des jeweiligen Kanalkopplungselements schließt sich außenseitig der Kühlmittelkammer fluidisch an die entsprechende Öffnung an. Alternativ kann das jeweilige erste Ende des jeweiligen Kanalkopplungselements in die entsprechende Öffnung eingesetzt sein. Das jeweilige erste Ende kann in die Kühlmittelkammer hineinragen, das heißt von einer Wand des Kühlkörpers, durch die die entsprechende Öffnung in die Kühlmittelkammer mündet, in die Kühlmittelkammer hinein hervorspringen. Ein jeweiliges zweites Ende des jeweiligen Kanalkopplungselements ist dazu eingerichtet, mit dem entsprechenden Kanal, das heißt mit dem Zulaufkanal oder mit dem Rücklaufkanal, des Kühlmittelkreislaufs fluidisch verbunden zu werden. Das jeweilige Kanalkopplungselement ist zum Beispiel separat von dem Kühlkörper, folglich separat von den Öffnungen ausgebildet und dann in die entsprechende Öffnung eingesetzt oder an die entsprechende Öffnung angesetzt und insbesondere an/in besagter Öffnung fixiert. Das Kanalkopplungselement kann beispielsweise in die entsprechende Öffnung eingeschraubt sein, wofür das Kanalkopplungselement dann an dessen erstem Ende ein Außengewinde aufweist und die entsprechende Öffnung ein mit dem Außengewinde zum Herstellen einer Gewinde- bzw. Schraubverbindung korrespondierendes Innengewinde aufweist. Für ein besonders einfaches Einschrauben des Kanalkopplungselements, insbesondere mithilfe eines Schraubwerkzeugs, kann das Kanalkopplungselement außenumfangsseitig ein Angriffselement für ein Schraubwerkzeug, etwa einen Vielkantkörper, aufweisen. Alternativ oder zusätzlich kann das Kanalkopplungselement unter Ausbildung eines Längs- oder Querpressverbands in die entsprechende Öffnung eingepresst sein. Wiederum alternativ oder zusätzlich kann das Kanalkopplungselement an/in die entsprechende Öffnung an-/eingeschweißt sein (beispielsweise mittels Reib-, Ultraschall- und/oder Laserschweißens), an-/eingeklebt, an-/eingelötet etc. In den Fällen, in denen das Kanalkopplungselement in die entsprechende Öffnung eingesetzt oder eingelegt ist, kann das Kanalkopplungselement einen Kragen aufweisen, der außenseitig an dem Kühlkörper zum Anliegen kommt, wodurch eine bestimmungsgemäße Einbaulage des Kanalkopplungselements sichergestellt ist. Das Kanalkopplungselement und die entsprechend zugehörige der Öffnungen können gemeinsam mit dem Kühlkörper, insbesondere dessen Kühlmittelkammerdeckel, urgeformt sein. Das Kanalkopplungselement kann zum Beispiel im Rahmen des generativen und/oder additiven Herstellens des Kühlkörpers (oder eines Teils davon) oder im Rahmen des Gießens des Kühlrohkörpers (oder eines Teils davon) ausgebildet werden. Ferner kann das Kanalkopplungselement im Rahmen eines Nachbearbeitens des Kühlrohkörpers oder des Kühlkörpers spanend und/oder spanlos ausgebildet werden. Aufgrund des jeweiligen Kanalkopplungselements ist das Kühlmittelkanalwerk des Kühlmittelkreislaufs, das heißt das Rohr- und/oder Schlauchwerk, auf besonders einfache bzw. aufwandsarme Weise an die Öffnungen und infolgedessen an die Kühlmittelkammer fluidisch anschließbar. Zudem kann das jeweilige Kanalkopplungselement als ein Winkelstück ausgeführt sein, sodass die Kanäle des Kühlmittelkanalwerks besonders vorteilhaft verlegt werden können.

In einer weiteren möglichen Ausführungsform weist der Kontaktierungspinträger die bereits erwähnte Befestigungseinrichtung auf.

In diesem Zusammenhang ist gemäß einer weiteren möglichen Ausführungsform vorgesehen, dass eine Längsmittenhauptachse der Befestigungseinrichtung und eine Längsmittenhauptachse der Einströmöffnung zusammenfallen. Anders ausgedrückt bildet die Längsmittenhauptachse der Befestigungseinrichtung in axialer Verlängerung die Längsmittenhauptachse der Einströmöffnung (bzw. umgekehrt), da generell bei dem Kontaktierungselementträger eine kühlmittelkammerseitige Mündung der Einströmöffnung und die Befestigungseinrichtung entlang der jeweiligen Längsmittenhauptachse voneinander beabstandet sind. Das bedeutet für den Betrieb des Kontaktierungspinträgers bzw. des Kontaktierungselements bzw. der Steckverbindungseinrichtung, dass das Kühlmittel unter dem Einströmen in die Kühlmittelkammer (bzw. direkt danach) einen Wandbereich der Kühlmittelkammer anströmt, über welchen die Befestigungseinrichtung und die Kühlmittelkammer in gerader Linie voneinander abgegrenzt sind. Hierdurch wir der Wandbereich besonders effizient entwärmt, was zu einer besonders effizienten Kühlung des Kontaktierungspins führt.

Die Befestigungseinrichtung, weist gemäß einer weiteren möglichen Ausgestaltung eine Innengewindehülse oder -buchse auf, deren Innengewinde mit einem Außengewinde des Kontaktierungspins korrespondiert, wobei die Innengewindehülse und ein Hülsensitz bzw. Buchsensitz der Befestigungseinrichtung miteinander einen Pressverband bilden. Insoweit ist also die Innengewindehülse in den Hülsensitz eingepresst. Dabei kann ein Längspressverband und/oder oder ein Querpressverband hergestellt sein. Bei letzterem kann Aufschrumpfen und/oder Kaltdehnen zum Herstellen des Pressverbandes eingesetzt werden. Es sind ferner Kombinationen der genannten Verbindungsvorrichtungen denkbar. Hierdurch kann der Kontaktierungspin auf besonders einfache Art in die Befestigungseinrichtung eingeschraubt werden, nämlich in die Gewindehülse. Alternativ kann der Kontaktierungspin direkt in den Hülsensitz eingepresst werden, wofür dann der Kontaktierungsabschnitt des Kontaktierungspins (ohne Hülse) als Pressverbandpartner für den Pressverband fungiert. Das Ausbilden des Au-ßen- und des Innengewindes entfallen in dem Fall.

Einer weiteren möglichen Ausführungsform zufolge weist der Kühlmittelkammeranteil außenseitig einen Sensorsitz auf, der dazu eingerichtet ist, einen Temperatursensor einer Temperaturmesseinrichtung zum Messen einer Temperatur des Kontaktierungspinträgers aufzunehmen. Die Temperaturmesseinrichtung ist zum Beispiel Teil des Kraftfahrzeugs, insbesondere der Steckverbindungseinrichtung. Sie ist dazu eingerichtet, im Betrieb des Kontaktierungspinträgers bzw. des Kontaktierungselements bzw. der Steckverbindungseinrichtung eine Betriebstemperatur zu überwachen. Durch die hierin beschriebene Anordnung des Temperatursensors kann besonders sicher und zuverlässig eine Temperatur des Kontaktierungspinträgers bzw. des Kontaktierungselements bzw. der Steckverbindungseinrichtung gemessen werden. Bei einer Überhitzung kann eine vorgegebene Gegenmaßnahme eingeleitet werden, beispielsweise ein Verringern der Lade-/Entladeleistung, ein Erhöhen einer Kühlleistung, ein Abbrechen des Lade-/Entladevorgangs etc. Da das Material des Kühlkörpers und das Material des Kontaktierungspins besonders gut wärmeleitend sind, ist der Temperatursensor am Kühlmittelkammeranteil hinsichtlich seiner Einbauposition besonders vorteilhaft, da die Temperatur des Kontaktierungspins und/oder des Kühlkörpers besonders genau gemessen werden kann. Zudem ist der Temperatursensor, da er außenseitig an dem Kühlkörper angeordnet ist, besonders einfach erreichbar/zugänglich. So kann der Temperatursensor mit einem Schaltungsträger, zum Beispiel einer Platine, der Steckverbindungseinrichtung besonders aufwandsarm elektrisch kontaktiert werden, insbesondere direkt auf den Schaltungsträger bzw. auf die Platine aufgesetzt werden. Dadurch ist eine besonders einfache Herstellung, insbesondere eine ganz oder teilweise automatisierte, etwa roboterunterstützte Herstellung des Kontaktierungselements und infolgedessen der Steckverbindungseinrichtung unterstützt.

Nach einer weiteren möglichen Ausgestaltung sind der Sensorsitz und die Befestigungseinrichtung an einer gemeinsamen Fläche des Kühlmittelkammeranteils angeordnet. Beispielsweise weist der Kühlmittelkammeranteil eine Stirnfläche auf, an der die Befestigungsrichtung angeordnet ist, insbesondere sich von der Stirnfläche wegerstreckt. Dies ist insbesondere bei der asymmetrischen Außengestalt des Kühlmittelkammeranteils von Vorteil, da die Stirnfläche in diesem Fall einen für den Sensorkopf ausreichen großen freien Bereich aufweist, der an die Befestigungseinrichtung angrenzt. So kann der Sensorkopf besonders nah an die Befestigungseinrichtung, und infolgedessen bei dem Kontaktierungselement besonders nah an den Kontaktierungspin, angebracht werden.

Der Sensorsitz weist eine in vorteilhafter Weise besonders einfache Struktur auf und lässt sich besonders einfach und/oder aufwandsarm fertigen, wenn - wie in einer möglichen Weiterbildung vorgesehen ist - der Sensorsitz ein in den Kühlmittelkammeranteil gebildetes Sackloch aufweist. Ein Innendurchmesser des Sacklochs korrespondiert zumindest mit einem Außendurchmesser eines Sensorkopfes des Temperatursensors, über welchen der Temperatursensor in das Sackloch, das heißt in den Kühlmittelkammeranteil des Kühlkörpers, aufgenommen ist. Es kann vorgesehen sein, dass der Sensorkopf in das Sackloch eingesetzt ist, dabei eine Innenumfangsfläche des Sacklochs wärmeleitend berührt und positionell in dem Sackloch gehalten wird, indem der Schaltungsträger, auf/an dem der Temperatursensor fixiert ist, in Bezug zu dem Kühlkörper fixiert ist. Alternativ oder zusätzlich ist der Einsatz einer kraft-, form- und/oder stoffschlüssigen Verbindung zwischen dem Sensorkopf und dem Sackloch denkbar, etwa dass der Sensorkopf in das Sackloch eingepresst, eingeklebt etc. ist.

In einer weiteren möglichen Ausführungsform des erfindungsgemäßen Kontaktierungselements sind der Kühlkörper und der Kontaktierungspin einstückig miteinander ausgebildet. In diesem Zusammenhang ist zu verstehen, dass es sich bei der Befestigungseinrichtung insbesondere um einen Materialbereich handeln kann, in den ein Material des Kontaktierungspins nahtlos übergeht. Das den Kontaktierungspin und den damit einstückig ausgebildeten Kühlkörper aufweisende Kontaktierungselement stellt eine besonders stabile und zuverlässige sowohl elektrische als auch mechanische Verbindung zwischen dem Kühlkörper und dem Kontaktierungspin bereit. Zudem ist das Kontaktierungselement besonders einfach, nämlich mittels besonders weniger Prozessschritte, herstellbar.

Die erfindungsgemäße Steckverbindungseinrichtung weist als ein erstes Kontaktierungselement das hierin beschrieben Kontaktierungselement oder eine mögliche Ausführungsform davon auf. Ferner weist die Steckverbindungseinrichtung ein weiteres Kontaktierungselement auf, das gleich oder spiegelbildlich zu dem ersten Kontaktierungselement ausgebildet sein kann. Zudem weist die Steckverbindungseinrichtung den mit dem Kühlmittel durchströmbaren Kühlmittelkreislauf auf, der das Kühlmittelkanalwerk umfasst. Das erste Kontaktierungselement ist im Betrieb der Steckverbindungseinrichtung - zum Beispiel in einem Lade- und/oder Entladebetrieb, in dem die Traktionsbatterie des Kraftfahrzeugs elektrisch ge-/entladen wird - mittels des Kühlmittelkreislaufs kühlbar. Hierzu ist die Einströmöffnung mit dem Zulaufkanal des Kühlmittelkreislaufs fluidisch verbunden, und die Ausströmöffnung ist mit dem Rücklaufkanal des Kühlmittelkreislaufs fluidisch verbunden.

Weitere Vorteile, Merkmale und Einzelheiten der Erfindung können sich aus der nachfolgenden Beschreibung möglicher Ausführungsbeispiele sowie anhand der Zeichnung ergeben. Die vorstehend in der Beschreibung genannten Merkmale und Merkmalskombinationen sowie die nachfolgend in der Figurenbeschreibung und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

### Kurze Figurenbeschreibung

Die Zeichnung zeigt in:
- Fig. 1: in entlang einer Schnittebene II-II (siehe Fig. 2) geschnittener Ansicht ein Kontaktierungselement, das einen Kontaktierungspinträger und einen Kontaktierungspin aufweist, und
- Fig. 2: in perspektivischer Ansicht eine Steckverbindungseinrichtung, die zwei spiegelbildlich ausgeführte Kontaktierungselemente aufweist.

Gleiche und funktionsgleiche Elemente sind in den Figuren mit gleichem Bezugszeichen versehen. Im Folgenden werden ein Kontaktierungspinträger 1, ein den Kontaktierungspinträger 1 aufweisendes Kontaktierungselement 2 sowie eine das Kontaktierungselement 2 aufweisende Steckverbindungseinrichtung 3 in gemeinsamer Beschreibung erläutert.

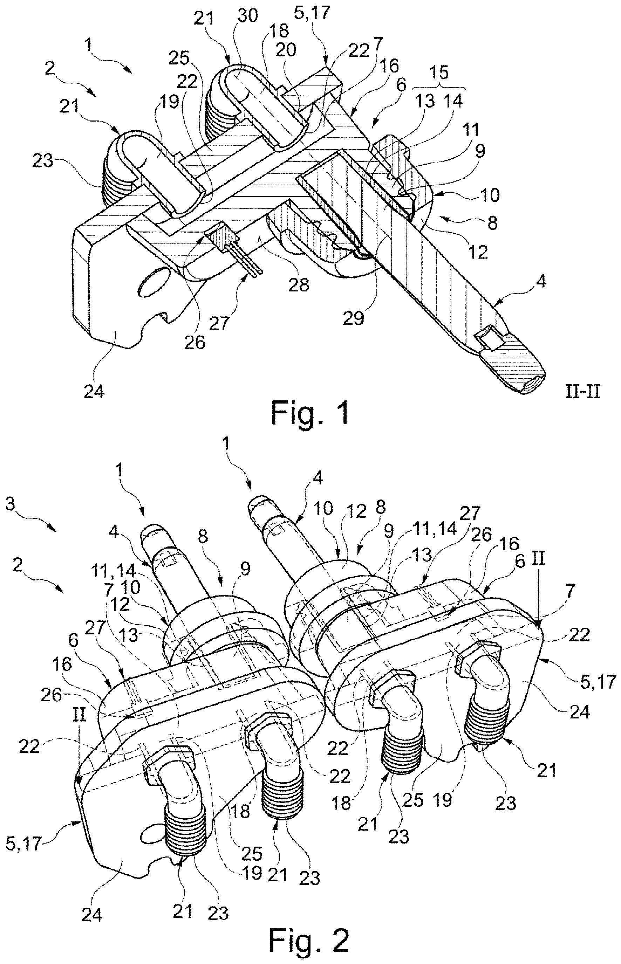

Hierzu zeigt Fig. 1 in entlang einer Schnittebene II-II (siehe Fig. 2) geschnittener Ansicht das Kontaktierungselement 2, das den Kontaktierungspinträger 1, einen Kontaktierungspin 4 und einen Stromschienenkörper 5 aufweist. Ein Kühlkörper 6 des Kontaktierungspinträgers 1 begrenzt eine von einem elektrisch nichtleitenden Kühlmittel (nicht dargestellt) durchströmbare Kühlmittelkammer 7 und ist aus einem elektrisch leitfähigen Material, hier im Beispiel Kupfer, ausgebildet. Der Kühlkörper 6 ist außenseitig und/oder innenseitig mit einer Korrosionsschutzbeschichtung beschichtet. Mittels einer Befestigungseinrichtung 8 des Kontaktierungspinträgers 1, ist der Kontaktierungspin 4 (hier als Vollpin ausgeführt), über dessen Befestigungsabschnitt 9 am Kontaktierungspinträger 1 bzw. an dessen Kühlkörper 6 fixiert und gleichzeitig elektrisch leitend mit dem Kühlkörper 6 kontaktiert. Vorliegend weist die Befestigungseinrichtung 8 eine Spanneinheit 10 auf, in dessen Befestigungsabschnittaufnahme 11 der Befestigungsabschnitt 9 des Kontaktierungspins 4 eingesetzt ist. Zu der Spanneinheit 10 gehört zudem eine Überwurfmutter 12, mittels derer die Befestigungsabschnittaufnahme 11 an den Befestigungsabschnitt 9 gespannt ist, sodass zwischen dem Befestigungsabschnitt 9 und der Befestigungsabschnittaufnahme 11 eine kraftschlüssige und elektrisch leitende Verbindung hergestellt ist. Zumindest ein Teil der Befestigungseinrichtung 8, hier die Befestigungsabschnittaufnahme 11, und der Kühlkörper 6 sind einstückig miteinander ausgebildet. Es ist alternativ denkbar, dass der Kontaktierungspin 4 und der Kühlkörper 6 einstückig miteinander ausgebildet sind. In diesem Fall ist die Befestigungseinrichtung 8 als ein Materialübergangsbereich ausgebildet, in dem das Material des Kühlkörpers 6 und ein Material des Kontaktierungspins 4 nahtlos ineinander übergehen.

Vorliegend weist die Befestigungseinrichtung 8 eine Innengewindehülse 13 auf, deren Innengewinde mit einem Außengewinde des Kontaktierungspins 4 korrespondiert, das an dessen Befestigungsabschnitt 9 angeordnet ist. Dabei bilden die Innengewindehülse 13 und ein Hülsensitz 14 der Befestigungseinrichtung 8 miteinander einen Pressverband 15. Der Kontaktierungspin 4 ist dann in die als Hülsensitz 14 ausgeführte Befestigungsabschnittaufnahme 11 eingeschraubt. Zudem ist eine Ausführungsform denkbar bei der der Kontaktierungspin 4 direkt - das heißt ohne Hülse - in den Hülsensitz 14 eingesetzt, insbesondere eingepresst ist. Eine Kombination aus Hülsensitz-Innengewindehülse-Anordnung und Spanneinheit 10 ist genauso gut denkbar. In diesem Fall kann die Innengewindehülse 13 in den Hülsensitz 14 eingesetzt und/oder -gepresst und mittels der Überwurfmutter 12 gesichert sein.

Der Kühlkörper 6 ist zum Beispiel mittels eines spanlosen Fertigungsverfahrens und/oder mittels eines spanenden Fertigungsverfahrens hergestellt, wobei es sich bei dem Kühlkörper 6 insbesondere um ein monolithisches Bauteil handeln kann. Im hier erläuterten Beispiel ist der Kühlkörper 6 zweiteilig ausgebildet und umfasst einen Kühlmittelkammeranteil 16 und einen separat davon ausgebildeten Kühlmittelkammerdeckel 17. Diese sind kraft-, form- und/oder stoffschlüssig miteinander verbunden, zum Beispiel verschraubt, vorliegend miteinander verschweißt. Die Kühlmittelkammer 7 ist so - abgesehen von einer Einströmöffnung 18 und einer Ausströmöffnung 19 - von dem Kühlmittelkammeranteil 16 zusammen mit dem Kühlmittelkammerdeckel 17 vollständig umschlossen. Zum Herstellen des Kühlmittelkammeranteils 16 kommt zum Beispiel Kaltfließpressen zum Einsatz.

Die Einströmöffnung 18 durchdringt den Kühlmittelkammerdeckel 17 des Kühlkörpers 6 und mündet in die Kühlmittelkammer 7. Ferner ist die Einströmöffnung 18 dazu eingerichtet, außenseitig des Kühlkörpers 6 mit einem Zulaufkanal eines Kühlmittelkreislaufs (nicht dargestellt) der Steckverbindungseinrichtung 3 fluidisch verbunden zu werden. In analoger Weise durchdringt die Ausströmöffnung 19 den Kühlmittelkammerdeckel 17 und ist dazu eingerichtet, außenseitig des Kühlkörpers 6 mit einem Rücklaufkanal des Kühlmittelkreislaufs der Steckverbindungseinrichtung 3 fluidisch verbunden zu werden. Die jeweilige Öffnung 18, 19 weist eine jeweilige eine kühlmittelkammerseitige Mündung 20 auf, über welche die entsprechende Öffnung 18, 19 in die Kühlmittelkammer 7 mündet. In Abweichend von den Fig. kann vorgesehen sein, dass die Öffnungen 18, 19 an jeweils unterschiedlichen Gehäusewänden des Kühlkörper 6 ausgebildet sind. Zum Beispiel kann die Einströmöffnung 18 den Kühlmittelkammerdeckel 17 durchdringen, wohingegen die Ausströmöffnung 19 den Kühlmittelkammeranteil 16 durchdringen kann.

Des Weiteren weist der Kontaktierungspinträger 1 - vorliegende je Öffnung 18, 19 - ein Kanalkopplungselement 21 auf, dessen jeweiliges erstes Ende 22 sich beispielsweise außenseitig der Kühlmittelkammer 7 fluidisch an die entsprechende Öffnung 18, 19 anschließt. Vorliegend ist das jeweilige erste Ende 22 des jeweiligen Kanalkopplungselements 21 in die entsprechende Öffnung 18, 19 passend eingesetzt. Jedenfalls ist ein jeweiliges zweites Ende 23 des jeweiligen Kanalkopplungselements 21 dazu eingerichtet, mit dem entsprechenden Kanal - das heißt mit dem Zulaufkanal bzw. mit dem Rücklaufkanal - des Kühlmittelkreislaufs fluidisch verbunden zu werden. Es ist zu erkennen, dass das jeweilige erste Ende 22 in der Kühlmittelkammer 7 die jeweilige kühlmittelkammerseitige Mündung 20 überragt bzw. von der jeweiligen Mündung 20 nach innen hervorspringt.

Des Weiteren handelt es sich bei dem Kühlmittelkammerdeckel 17 und dem Stromschienenkörper 5 um ein identisches Bauteil, was bedeutet, dass der Kühlmittelkammerdeckel 17 als der Stromschienenkörper 5 für das Kontaktierungselement 2 ausgebildet ist (oder umgekehrt). Der Stromschienenkörper 5, also folglich der Kühlmittelkammerdeckel 17, weist einen Anschlussabschnitt 24 auf, der stoffschlüssig mit einem Hauptkörperabschnitt 25 des Kühlmittelkammerdeckels 17 verbunden ist. Hier im Beispiel sind der Anschlussabschnitt 24 und der Hauptkörperabschnitt 25 einstückig miteinander ausgebildet.

In einem Betrieb des Kontaktierungspinträgers 1 bzw. des den Kontaktierungspinträger 1 aufweisenden Kontaktierungselements 2 bzw. der das Kontaktierungselement 2 aufweisenden Steckverbindungseinrichtung 3 fungieren der Kühlkörper 6 - das heißt der Kühlmittelkammeranteil 16 und der Kühlmittelkammerdeckel 17 bzw. der Stromschienenkörper 5 -, der damit mechanisch verbundene und elektrisch kontaktierte Kontaktierungspin 4 als stromführende Elemente. Bei dem Betrieb handelt es sich zum Beispiel um einen Ladebetrieb einer Traktionsbatterie eines ganz oder teilweise elektrisch antreibbaren Kraftfahrzeugs. Im Betrieb wird mittels des Kühlmittelkreislaufs das Kühlmittel angetrieben, das dadurch durch ein Kühlmittelkanalwerk des Kühlmittelkreislaufs getrieben wird. Da der Zulaufkanal des Kühlmittelkreislaufs fluidisch mit der Einströmöffnung 18 verbunden ist (vorliegend mittels des in die Einströmöffnung 18 eingesetzten Kanalkopplungselements 21) wird das Kühlmittel durch das Kanalkopplungselement 21, durch die Einströmöffnung 18 und infolgedessen in die Kühlmittelkammer 7 hineingepumpt. Dort streicht/strömt das Kühlmittel innenseitig an dem Kühlkörper 6 vorbei und nimmt dabei Wärme auf, die durch einen elektrischen Strom, der im Betrieb durch den Stromschienenkörper 5 bzw. den Kühlmittelkammerdeckel 17 und/oder den Kühlmittelkammeranteil 16 und/oder den Kontaktierungspin 4 fließt, auf. Das so erwärmte Kühlmittel strömt dann durch die Ausströmöffnung 19, vorliegend mittels des in die Ausströmöffnung 19 eingesetzten Kanalkopplungselements 21, in den Rücklaufkanal des Kühlmittelkreislaufs, wodurch die Wärme abtransportiert wird und dementsprechend der Stromschienenkörper 5, der Kühlkörper 6 und der Kontaktierungspin 4 gekühlt werden. So kommt es in den genannten stromführenden Bauteilen im Betrieb nicht oder nur in stark verringertem Maße zu einer wärmeinduzierten Erhöhung des ohmschen Widerstands, wodurch höhere Ladeleistungen dargestellt werden können. Dieser Effekt wird verstärkt, wenn in der Kühlmittelkammer ein Kühlmittelkanal (nicht dargestellt) ausgebildet ist, dessen Mäanderform eine mäanderförmige Strömung des Kühlmittels in der Kühlmittelkammer erzwingt.

Außenseitig weist der Kühlmittelkammeranteil 16 einen Sensorsitz 26 auf, in welchen ein Sensorkopf eines Temperatursensors 27 einer Temperaturmesseinrichtung (nicht dargestellt) eingesetzt ist. Mittels des Temperatursensors wird im Betrieb eine Temperatur des Kontaktierungspinträgers 1 gemessen. Der Sensorsitz 26 ist vorliegend als ein Sackloch ausgebildet, das zusammen mit der Befestigungseinrichtung 8 an einer gemeinsamen Fläche 28 des Kühlmittelkammeranteils 16 angeordnet ist. Mit anderen Worten ist das Sackloch bzw. der Sensorsitz 26 an derselben Fläche 28 des Kühlkörpers 6 bzw. des Kontaktierungspinträgers 1 angeordnet, von der auch die Befestigungseinrichtung 8 hervorspringt. Der Sensorkopf kann kraft-, form- und/oder stoffschlüssig im Sensorsitz 26 fixiert sein.

Eine Längsmittenhauptachse 29 der Befestigungseinrichtung 8 und eine Längsmittenhauptachse 30 der Einströmöffnung 18 fallen hier im Beispiel zusammen, sodass im Betrieb ein besonders vorteilhaftes Anströmen eines Wandbereichs der Kühlmittelkammer 7 erreicht wird, über welchen die Befestigungseinrichtung 8 und die Kühlmittelkammer 7 in gerader Linie voneinander abgegrenzt sind. Wie aus Fig. 1 weiter ersichtlich ist, ist der Kühlkörper 6 - und infolgedessen die Kühlmittelkammer 7 - asymmetrisch ausgeführt, und die Befestigungseinrichtung 8 ist in Bezug zu der Kühlmittelkammer 7 exzentrisch angeordnet. So wird bei vorgegebenem Pitch-Maß eine vorteilhaft besonders großvolumige Kühlmittelkammer 7 erreicht.

Fig. 2 zeigt in perspektivischer Ansicht die Steckverbindungseinrichtung 3, die zwei spiegelbildlich ausgeführte Kontaktierungselemente 2 aufweist. Ein Gehäuse der Steckverbindungseinrichtung 3, mittels dessen insbesondere eine elektrische Isolierung zwischen den beiden Kontaktierungselementen 2 realisiert ist, ist in Fig. 2 nicht dargestellt.

### BEZUGSZEICHENLISTE

- 1: Kontaktierungspinträger
- 2: Kontaktierungselement
- 3: Steckverbindungseinrichtung
- 4: Kontaktierungspin
- 5: Stromschienenkörper
- 6: Kühlkörper
- 7: Kühlmittelkammer
- 8: Befestigungseinrichtung
- 9: Befestigungsabschnitt
- 10: Spanneinheit
- 11: Befestigungsabschnittaufnahme
- 12: Überwurfmutter
- 13: Innengewindehülse
- 14: Hülsensitz
- 15: Pressverband
- 16: Kühlmittelkammeranteil
- 17: Kühlmittelkammerdeckel
- 18: Einströmöffnung
- 19: Ausströmöffnung
- 20: kühlmittelkammerseitige Mündung
- 21: Kanalkopplungselement
- 22: erstes Ende des Kanalkopplungselements
- 23: zweites Ende des Kanalkopplungselements
- 24: Anschlussabschnitt
- 25: Hauptkörperabschnitt
- 26: Sensorsitz
- 27: Temperatursensor
- 28: Fläche
- 29: Längsmittenhauptachse der Befestigungseinrichtung
- 30: Längsmittenhauptachse der Einströmöffnung

## Patentansprüche

1. Kontaktierungspinträger (1) für ein Kontaktierungselement (2) einer zum Herstellen einer elektrisch leitfähigen Steckverbindung (3) ausgebildeten Steckverbindungseinrichtung (3), wobei der Kontaktierungspinträger (1) aufweist:
- einen Kühlkörper (6), der
- eine mit einem elektrisch nichtleitenden Kühlmittel durchströmbare Kühlmittelkammer (7) begrenzt,
- aus einem elektrisch leitfähigen Material ausgebildet ist,
- einen Kühlmittelkammeranteil (16) und einen Kühlmittelkammerdeckel (17) aufweist, die miteinander verbunden sind,
- eine Einströmöffnung (18), die den Kühlmittelkammerdeckel (17) durchdringt, in die Kühlmittelkammer (7) mündet und dazu eingerichtet ist, außenseitig des Kühlkörpers (6) mit einem Zulaufkanal eines Kühlmittelkreislaufs fluidisch verbunden zu werden,
- eine von der Einströmöffnung (18) separat ausgebildete Ausströmöffnung (19), die den Kühlmittelkammerdeckel (17) durchdringt, in die Kühlmittelkammer (7) mündet und dazu eingerichtet ist, außenseitig des Kühlkörpers (6) mit einem Rücklaufkanal des Kühlmittelkreislaufs fluidisch verbunden zu werden.

2. Kontaktierungspinträger (1) nach Anspruch 1,
**dadurch gekennzeichnet, dass**
der Kühlmittelkammeranteil (16) und der Kühlmittelkammerdeckel (17) separat voneinander hergestellt und kraft-, form- und/oder stoffschlüssig miteinander verbunden sind.

3. Kontaktierungspinträger (1) nach Anspruch 1 oder 2,
**dadurch gekennzeichnet, dass**
der Kühlmittelkammerdeckel (17) als ein Stromschienenkörper (5) für das Kontaktierungselement (2) ausgebildet ist und hierzu einen Anschlussabschnitt (24) aufweist, der stoffschlüssig mit einem Hauptkörperabschnitt (25) des Kühlmittelkammerdeckels (17) verbunden ist.

4. Kontaktierungspinträger (1) nach einem der vorhergehenden Ansprüche,
**dadurch gekennzeichnet, dass**
in der Kühlmittelkammer (7) ein Kühlmittelkanal ausgebildet ist, der sich einerseits fluidisch an die Einströmöffnung (18) und andererseits fluidisch an die Ausströmöffnung (19) anschließt, wobei durch den Kühlmittelkanal ein Mäander in der Kühlmittelkammer (7) gebildet ist.

5. Kontaktierungspinträger (1) nach einem der vorhergehenden Ansprüche,
**dadurch gekennzeichnet, dass**
der Kühlmittelkammeranteil (16) und/oder der Kühlmittelkammerdeckel (17) mittels eines spanlosen Fertigungsverfahrens und/oder mittels eines spanenden Fertigungsverfahrens hergestellt sind/ist.

6. Kontaktierungspinträger (1) nach einem der vorhergehenden Ansprüche,
**gekennzeichnet durch**
ein Kanalkopplungselement (21), dessen erstes Ende (22) sich außenseitig der Kühlmittelkammer (7) fluidisch an eine der Öffnungen (18, 19) anschließt oder dessen erstes Ende (22) in die entsprechende Öffnung (8, 19) eingesetzt ist, wobei ein zweites Ende (23) des Kanalkopplungselements (21) dazu eingerichtet ist, mit dem entsprechenden Kanal des Kühlmittelkreislaufs fluidisch verbunden zu werden.

7. Kontaktierungspinträger (1) nach einem der vorhergehenden Ansprüche,
**gekennzeichnet durch**
eine Befestigungseinrichtung (8), die am Kühlkörper (6) ausgebildet und dazu eingerichtet ist, einen Kontaktierungspin (4) des Kontaktierungselements (2) außenseitig am Kühlkörper (6) zu fixieren und dabei den Kontaktierungspin (4) mit dem Kühlkörper (6) elektrisch zu kontaktieren.

8. Kontaktierungspinträger (1) nach Anspruch 7,
**dadurch gekennzeichnet, dass**
eine Längsmittenhauptachse (29) der Befestigungseinrichtung (8) und eine Längsmittenhauptachse (30) der Einströmöffnung (18) zusammenfallen.

9. Kontaktierungspinträger (1) nach Anspruch 7 oder 8,
**dadurch gekennzeichnet, dass**
die Befestigungseinrichtung (8) eine Innengewindehülse (13) aufweist, deren Innengewinde mit einem Außengewinde des Kontaktierungspins (4) korrespondiert, wobei die Innengewindehülse (13) und ein Hülsensitz (14) der Befestigungseinrichtung (8) miteinander einen Pressverband (15) bilden.

10. Kontaktierungspinträger (1) nach einem der vorhergehenden Ansprüche,
**dadurch gekennzeichnet, dass**
der Kühlmittelkammeranteil (16) außenseitig einen Sensorsitz (26) aufweist, der dazu eingerichtet ist, einen Temperatursensor (27) einer Temperaturmesseinrichtung zum Messen einer Temperatur des Kontaktierungspinträgers (1) aufzunehmen.

11. Kontaktierungspinträger (1) nach Anspruch 10 und einem oder mehr der Ansprüche 7 bis 9, oder nach einem oder mehr der Ansprüche 1 bis 6 in Rückbezug auf Anspruch 10 und einen oder mehr der Ansprüche 7 bis 9,
**dadurch gekennzeichnet, dass**
der Sensorsitz (26) und die Befestigungseinrichtung (8) an einer gemeinsamen Fläche (28) des Kühlmittelkammeranteils (16) angeordnet sind.

12. Kontaktierungspinträger (1) nach Anspruch 10 oder 11,
**dadurch gekennzeichnet, dass**
der Sensorsitz (26) ein in den Kühlmittelkammeranteil (16) gebildetes Sackloch aufweist.

13. Kontaktierungselement (2) für eine Steckverbindungseinrichtung (3) für ein Kraftfahrzeug, wobei das Kontaktierungselement (2) einen nach einem oder mehr der vorhergehenden Ansprüche ausgebildeten Kontaktierungspinträger (1) und einen Kontaktierungspin (4), der an dem Kontaktierungspinträger (1) angeordnet und mit diesem elektrisch kontaktiert ist.

14. Kontaktierungselement (2) nach Anspruch 13,
**dadurch gekennzeichnet, dass**
der Kontaktierungspinträger (1), der ohne Rückbezug auf Anspruch 9 nach einem der Ansprüche 1 bis 8 oder 10 bis 12 ausgebildet ist, und der Kontaktierungspin (4) einstückig miteinander ausgebildet sind.

15. Steckverbindungseinrichtung (3) für ein Kraftfahrzeug, mittels derer eine elektrisch leitfähige Steckverbindung zwischen einer elektrischen Energiequelle und einer elektrischen Batterie herstellbar ist, wobei die Steckverbindungseinrichtung (3) aufweist:
- als einen ersten Kontaktierungspinträger den nach Anspruch 13 oder 14 ausgebildeten Kontaktierungspinträger (1),
- einen weiteren Kontaktierungspinträger
- einen mit einem Kühlmittel durchströmbaren Kühlmittelkreislauf,
wobei der erste Kontaktierungspinträger (1) mittels des Kühlmittelkreislaufs kühlbar ist, indem die Einströmöffnung (18) mit einem Zulaufkanal des Kühlmittelkreislaufs fluidisch verbunden ist und die Ausströmöffnung (19) mit einem Rücklaufkanal des Kühlmittelkreislaufs fluidisch verbunden ist.
